# FASCICULE DE BREVET EUROPEEN

(11) **EP 4 082 306 B1**
(45) Date de publication et mention de la délivrance du brevet: **01.05.2024**
(21) Numéro de dépôt: 20820454.5
(22) Date de dépôt: 14.12.2020
(51) Int. Cl.: H05K 7/20

(54) **DISPOSITIF DE DISSIPATION DE CHALEUR, SYSTÈME ÉLECTRIQUE COMPORTANT UN TEL DISPOSITIF ET PROCÉDÉ DE FABRICATION ASSOCIÉ**
WÄRMEABLEITUNGSVORRICHTUNG, ELEKTRISCHES SYSTEM MIT EINER SOLCHEN VORRICHTUNG UND ZUGEHÖRIGES HERSTELLUNGSVERFAHREN
HEAT DISSIPATION DEVICE, ELECTRICAL SYSTEM COMPRISING SUCH A DEVICE, AND ASSOCIATED MANUFACTURING METHOD

(30) Priorité: 24.12.2019 FR 1915594
(43) Date de publication de la demande: 02.11.2022
(73) Titulaire: Valeo Systemes de Controle Moteur, 95892 Cergy Pontoise Cedex (FR)
(72) Inventeur: SMAL, Pierre, 95892 Cergy Pontoise (FR); TALON, Emmanuel, 95892 Cergy Pontoise (FR); COIA, Arnaud, 95892 Cergy Pontoise (FR)
(74) Mandataire: Valeo Powertrain Systems
(86) Numéro de dépôt international: PCT/EP2020/085915
(87) Numéro de publication internationale: WO 2021/130039

(56) Documents cités:
- EP-A2- 2 528 091
- EP-A2- 2 528 091
- US-A1- 2003 169 983
- US-A1- 2003 169 983
- US-A1- 2008 068 805
- US-A1- 2008 068 805
- US-A1- 2012 103 589
- US-A1- 2012 103 589

## Description

La présente invention concerne un dispositif de dissipation de chaleur, un système électrique comportant un tel dispositif et un procédé de fabrication associé.

L'invention s'applique notamment à un dispositif de dissipation de chaleur du type comportant un dissipateur de chaleur principal comportant un corps principal présentant une face supérieure destinée à recevoir de la chaleur à dissiper, et des ailettes principales s'étendant sur une face inférieure du corps principal.

Le document EP 2 528 091 A2, US 2012/103589 A1, US 2008/068805 A1, US 2003/169983 A1 décrivent un dispositif de dissipation de chaleur du type précité.

L'invention vise à permettre d'utiliser des ailettes ayant une grande diversité géométrique.

À cet effet, il est proposé un dispositif de dissipation de chaleur selon la revendication 1.

Au sens de l'invention, une ailette est une saillie s'étendant sur la face inférieure du corps principal et destinée à augmenter la surface de transmission de la chaleur entre le corps principal et un fluide de refroidissement dans lequel baigne l'ailette.

Ainsi, une ailette peut être une ailette droite à section constante, une ailette droite à section variable ou une ailette en forme de plot conique, ou encore une ailette de forme quelconque.

L'invention permet ainsi de facilement combiner plusieurs géométries d'ailettes, en prévoyant une géométrie d'ailettes pour le dissipateur de chaleur principal et en complétant ce dernier avec un ou plusieurs dissipateurs de chaleur auxiliaires présentant des ailettes auxiliaires présentant une autre géométrie.

Le dispositif de dissipation peut comprendre avantageusement au moins un des perfectionnements ci-dessous, les caractéristiques techniques formant ces perfectionnements pouvant être prises seules ou en combinaison.

De façon optionnelle, les ailettes auxiliaires sont des ailettes droites à section constante ou des ailettes droites à section variable ou encore des ailettes en forme de plot conique.

De façon optionnelle, les ailettes principales sont des ailettes droites à section constante ou des ailettes droites à section variable ou encore des ailettes en forme de plot conique.

De façon optionnelle, les ailettes auxiliaires et les ailettes principales sont des ailettes droites à section constante et les ailettes auxiliaires présentent une épaisseur inférieure à une épaisseur des ailettes principales.

De façon optionnelle, les ailettes auxiliaires présentent une épaisseur inférieure à une épaisseur des ailettes principales.

De façon optionnelle également, les ailettes auxiliaires sont séparées les unes des autres d'un espacement inférieur à un espacement séparant les unes des autres les ailettes principales.

De façon optionnelle également, le dissipateur de chaleur principal est en une seule pièce d'un seul tenant.

De façon optionnelle également, chaque dissipateur de chaleur auxiliaire est en une seule pièce d'un seul tenant.

De façon optionnelle également, le dissipateur de chaleur auxiliaire est fixé au dissipateur de chaleur principal par un procédé de soudage par friction-malaxage.

De façon optionnelle également, le dissipateur de chaleur principal est obtenu par un premier procédé de fabrication, par exemple par fonderie, et chaque dissipateur de chaleur auxiliaire est obtenu par un deuxième procédé de fabrication, différent du premier, par exemple par extrusion.

De façon optionnelle également, chaque dissipateur de chaleur auxiliaire comporte en outre une partie se projetant latéralement du corps auxiliaire de manière à être plaquée contre et fixée à la face inférieure du corps principal du dissipateur de chaleur principal.

De façon optionnelle également, le dispositif de dissipation de chaleur comporte en outre au moins une gouttière s'étendant autour d'au moins certaines des ailettes principales et/ou auxiliaires de manière à délimiter avec le corps principal au moins un conduit de fluide de refroidissement.

De façon optionnelle également, le dispositif de dissipation de chaleur comporte en outre un système de mise en circulation d'un fluide de refroidissement dans le ou les conduits de fluide de refroidissement.

De façon optionnelle également, le dispositif de dissipation de chaleur comporte en outre un isolant thermique intercalé entre chaque dissipateur de chaleur auxiliaire et le dissipateur de chaleur principal.

Il est également proposé un système électrique comportant un circuit électrique, tel qu'un convertisseur de tension continu-continu, et un dispositif de dissipation de chaleur du circuit électrique, selon l'invention.

Il est également proposé un procédé de fabrication d'un dispositif de dissipation de chaleur selon l'invention, comportant : l'obtention du dissipateur de chaleur principal, l'obtention de chaque dissipateur de chaleur auxiliaire, et le placement du corps auxiliaire de chaque dissipateur de chaleur auxiliaire dans une ouverture respective du dissipateur de chaleur principal et la fixation de chaque dissipateur de chaleur auxiliaire au dissipateur de chaleur.

L'invention sera mieux comprise à la lumière de la description qui va suivre, donnée uniquement à titre d'exemple non limitatif et faisant référence aux figures suivantes :
[Fig. 1] La figure 1 est une vue en trois dimensions d'un système électrique selon l'invention, comportant en particulier un boîtier renfermant un circuit électrique et présentant des ailettes recouvertes par un guide d'air.
[Fig. 2] La figure 2 est une vue en coupe en trois dimensions du système électrique de la figure 1 sans le guide d'air.
[Fig. 3] La figure 3 est une vue en trois dimensions d'une pièce inférieure du boîtier de la figure 1.
[Fig. 4] La figure 4 est une vue en coupe en trois dimensions de la pièce inférieure et de dissipateurs de chaleur auxiliaires assemblés dans cette pièce inférieure.
[Fig. 5] La figure 5 est une vue en coupe de face de la pièce inférieure et des dissipateurs de chaleur auxiliaires assemblés dans cette pièce inférieure.
[Fig. 6] La figure 6 est une vue en trois dimensions de dessous du système électrique de la figure 1 avec un guide d'air en transparence.
[Fig. 7] La figure 7 est un schéma blocs illustrant les étapes d'un procédé de fabrication.

Dans la description et les revendications qui vont suivre, les éléments seront repérés dans l'espace par rapport à une direction verticale haut-bas arbitraire (désignée sur les figures par la référence V), pouvant correspondre à la direction verticale usuelle ou bien à une autre direction en fonction de l'orientation du système.

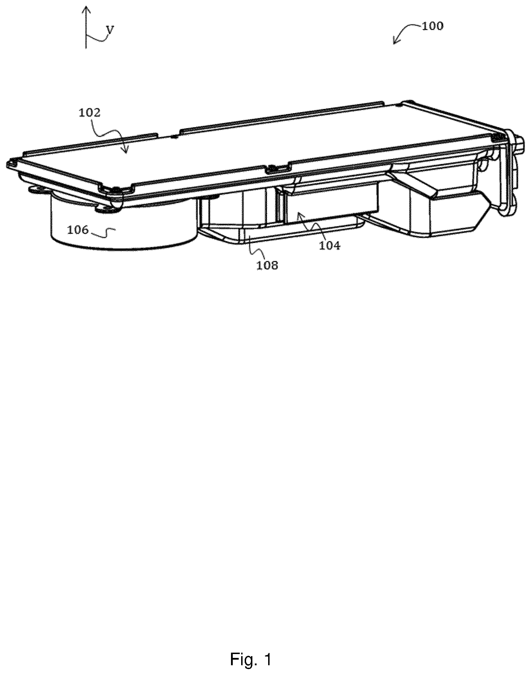

La figure 1 est une vue en trois dimensions d'un système électrique 100 selon l'invention.

Le système électrique 100 comporte tout d'abord un boîtier 102 renfermant un circuit électrique, non visible sur la figure 1 mais qui sera décrit plus en détail plus loin.

Pour évacuer la chaleur générée par le circuit électrique lors de son fonctionnement, le boîtier 102 est muni d'ailettes 104.

Dans l'exemple décrit ici, les ailettes 104 sont des ailettes droites à section constante.

En outre, de préférence, le système électrique 100 comporte au moins un système de mise en circulation d'un fluide de refroidissement en direction d'au moins une partie des ailettes 104.

Dans l'exemple décrit, le fluide de refroidissement est de l'air et le système de mise en circulation est un ventilateur 106 fixé au boîtier 102 et conçu pour générer un flux d'air en direction d'au moins une partie des ailettes 104.

En variante, le fluide de refroidissement peut être un liquide.

Afin de guider le fluide de refroidissement, le système électrique 100 peut en outre comporter un guide 108 couvrant au moins certaines des ailettes 104 de manière à répartir le fluide de refroidissement entre ces ailettes 104. Le guide 108 peut présenter une extrémité ouverte, par exemple lorsque le fluide de refroidissement est de l'air, ou bien faire partie d'un circuit fermé, par exemple lorsque le fluide de refroidissement comporte un liquide tel que de l'eau, de l'huile ou bien de l'azote liquide. Dans le cas d'un liquide, le système de mise en circulation peut comporter une pompe de mise en circulation de ce liquide.

En outre, le refroidissement peut être assuré par plusieurs fluides de refroidissement différents, par exemple de l'air et de l'eau. Dans ce cas, le système électrique 100 pourrait comporter un système de mise en circulation d'air en direction de certaines des ailettes 104 et un système de mise en circulation d'eau dans un circuit fermé, en direction d'autres des ailettes 104.

Enfin, certaines ailettes 104 peuvent ne pas être associées à un système de mise en circulation d'un fluide de refroidissement, mais simplement laissées au contact de l'air ambiant.

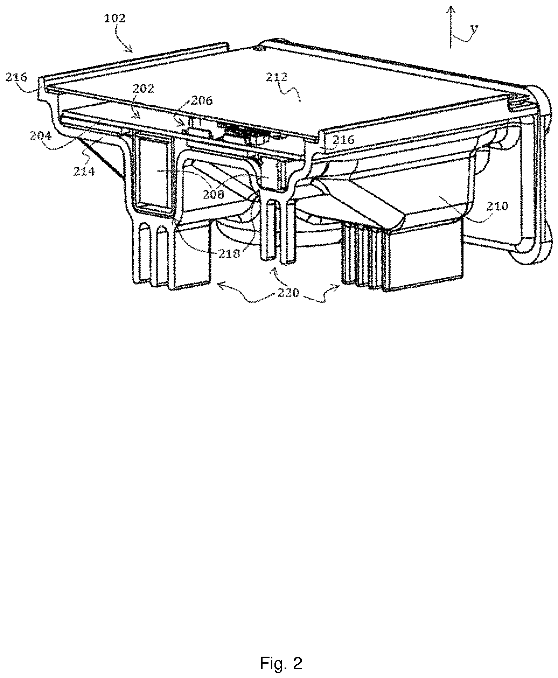

Sur la figure 2, qui est une vue en coupe en trois dimensions du système électrique 100 sans le guide 108, le circuit électrique est visible et repéré par la référence 202. Le circuit électrique 202 comporte une carte de circuit imprimé 204 portant, dans l'exemple illustré, des composants de petite taille 206 sur une face supérieure et/ou sur une face inférieure de la carte de circuit imprimé 204, et des composants de grande taille 208 sur la face inférieure. Dans l'exemple décrit, le circuit électrique 202 est un convertisseur de tension continu-continu.

Par ailleurs, le boîtier 102 comporte une pièce inférieure 210 en forme de baquet et une pièce supérieure 212 en forme de couvercle plat fermant le baquet. Plus précisément, la pièce inférieure 210 comporte un fond 214 et une paroi latérale périphérique 216 s'élevant depuis le fond 214 et délimitant une ouverture supérieure. La pièce supérieure 212 est ainsi reçue dans cette ouverture supérieure pour la fermer. Le fond 214 présente des renfoncements 218 recevant chacun un ou plusieurs des composants de grande taille 208.

La pièce inférieure 210 comporte en outre des ailettes principales 220 (droites à section constante) s'étendant sur une face inférieure (dirigée vers l'extérieur du boîtier 102) du fond 214. Le fond 214 et les ailettes principales 220 forment ainsi un dissipateur de chaleur principal 214, 220 conçu pour dissiper au moins une partie de la chaleur générée par le circuit électrique 102 lors de son fonctionnement, et arrivant sur la face supérieure du fond 214.

La pièce inférieure 210 est de préférence réalisée en une seule pièce d'un seul tenant selon un premier mode de fabrication. Par exemple, la pièce inférieure 210 est obtenue par fonderie, c'est-à-dire en utilisant un moule dans lequel est injecté un matériau sous pression. Ce matériau présente par exemple une conductivité thermique ne dépassant pas 130 W/mK. Il peut s'agir par exemple d'un alliage d'aluminium (comme AISi9Cu3 ou AISi12(Fe)). Cela permet de donner une forme complexe à la pièce inférieure 210 et en particulier de réaliser les renfoncements 218. Cependant, le premier mode de fabrication utilisé pour obtenir la pièce inférieure 210 peut imposer des limitations à la forme des ailettes principales 220. Par exemple, la fonderie d'une pièce de grande taille comme la pièce inférieure 210, ne permet pas de réaliser des ailettes fines ni rapprochées.

Pour remédier à cela, un ou plusieurs dissipateurs de chaleur auxiliaires (décrits plus loin) sont utilisés.

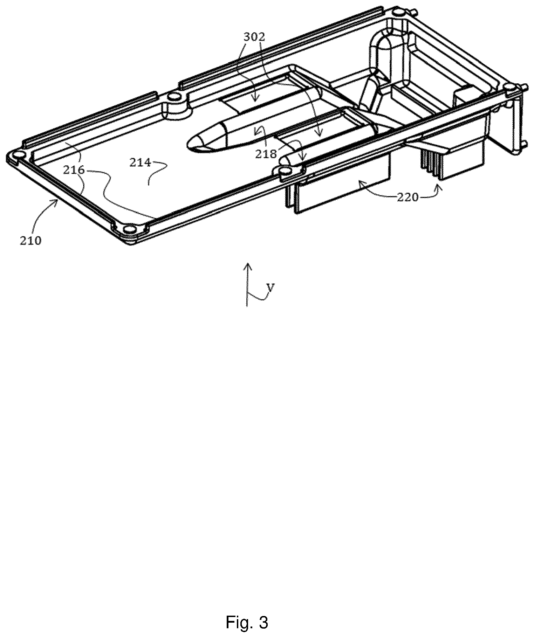

Ainsi, en référence à la figure 3, qui est une vue en trois dimensions de la pièce inférieure 210 seule, le fond 214 est pourvu d'au moins une ouverture 302 (rectangulaire dans l'exemple décrit) traversant le fond 214 de part en part, de sa face supérieure à sa face inférieure.

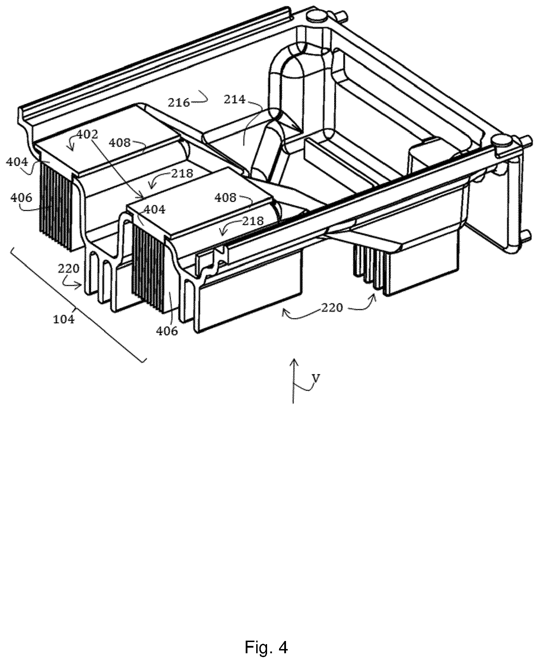

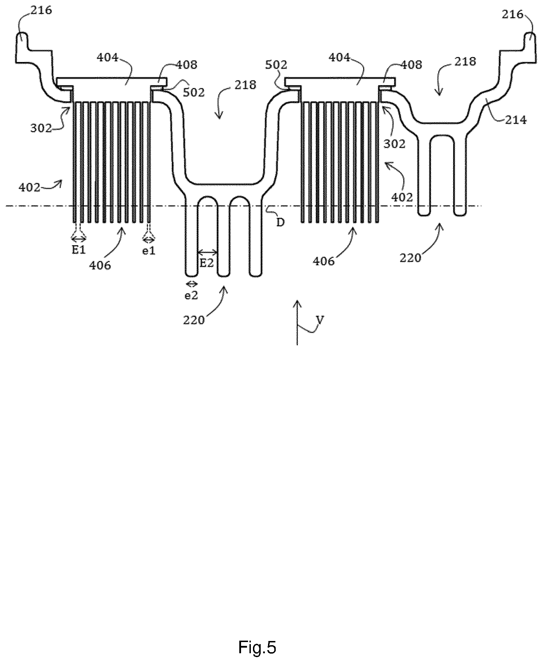

En référence aux figures 4 et 5, qui sont des vues en coupe respectivement en trois dimensions et de face de la pièce inférieure 210 et des dissipateurs de chaleur auxiliaires, le boîtier 102 comporte, pour chaque ouverture 302, un dissipateur de chaleur auxiliaire 402 placé dans l'ouverture 302 considérée.

Plus précisément, chaque dissipateur de chaleur auxiliaire 402 comporte un corps 404 placé dans l'ouverture 302. Chaque dissipateur de chaleur auxiliaire 402 comporte en outre des ailettes auxiliaires 406 (droites à section constante) s'étendant sur une face inférieure du corps 404, à côté des ailettes principales 220. Chaque dissipateur de chaleur auxiliaire 402 comporte en outre une collerette 408 se projetant latéralement du corps 404 à l'intérieur du boîtier 102 de manière à être plaquée contre et fixée à la face supérieure du fond 214, afin de fixer le dissipateur de chaleur auxiliaire 402 au fond 214.

Ainsi, le dissipateur de chaleur principal 214, 220 et le ou les dissipateurs de chaleur auxiliaires 402 forment ensemble un dispositif de dissipation de chaleur conçu pour dissiper la chaleur générée par le circuit électrique 102 et qui arrive sur la face supérieure du fond 214 et sur la face supérieure du corps auxiliaire 404 de chaque dissipateur de chaleur auxiliaire 402.

Comme cela est visible sur la figure 5, la fixation est par exemple assurée par une colle 502, par exemple une colle en silicone. Dans l'exemple décrit, la colle 502 forme une piste périphérique autour de l'ouverture 302 de largeur comprise entre 2 mm et 4 mm, par exemple 3 mm et d'épaisseur comprise entre 0,5 mm et 1,5 mm, par exemple 1 mm. De préférence, la colle 502 forme également un isolant thermique intercalé entre le ou les dissipateurs de chaleur auxiliaires 402 et le dissipateur de chaleur principal 214, 220. De préférence encore, la colle 502 peut être un isolant électrique afin d'améliorer la compatibilité électromagnétique (CEM) du boîtier 102.

De manière générale, les fonctions de fixation, d'isolation thermique et d'isolation électrique pourraient être réalisées par des éléments différents. De préférence, l'isolant thermique utilisé présente une conductivité thermique d'au plus 1 W/mK, de préférence d'au plus 0,4 W/mK, par exemple 0,2 W/mK pour la colle 502. De préférence également, l'isolant électrique utilisé présente une résistivité électrique d'au moins 100 Ohms/cm, de préférence d'au moins 600 Ohms/cm, par exemple 1 000 Ohms/cm pour la colle 502.

Alternativement, la fixation des dissipateurs de chaleur auxiliaire 402 au fond 214 pourrait être réalisée par vissage, brasure, soudure ou bien soudage par friction-malaxage (de l'anglais « friction stir welding »).

Chaque dissipateur de chaleur auxiliaire 402 est de préférence réalisé en une seule pièce d'un seul tenant. Le même procédé de fabrication que pour la pièce inférieure 210 peut être utilisé. En effet, de manière générale, pour un même procédé de fabrication, la finesse des pièces et leurs intervalles de tolérance sont proportionnels à la plus grande dimension de la pièce. Ainsi, le dissipateur de chaleur auxiliaire 402 étant de plus petite taille que la pièce inférieure 210, le même procédé de fabrication peut permettre de prévoir des ailettes plus fines et plus rapprochées. Alternativement, le dissipateur de chaleur auxiliaire 402 peut être réalisé selon un deuxième mode de fabrication, différent du premier. Cela procure les avantages suivants. Le deuxième mode de fabrication peut être plus économique que le premier mode de fabrication. En outre, il peut permettre d'utiliser, pour le dissipateur de chaleur auxiliaire 402, un matériau plus économique et/ou plus performant thermiquement que les matériaux utilisables par le premier mode de fabrication. Par exemple, le dissipateur de chaleur auxiliaire 402 est obtenu par extrusion, c'est-à-dire en poussant une pâte d'un matériau dans un tube (ou une filière) pour obtenir un profilé. Un matériau présentant une conductivité thermique supérieure à 150 W/mK, par exemple atteignant 200 W/mK, peut être utilisé. L'utilisation d'un ou plusieurs dissipateurs de chaleur auxiliaires 402 permet de combiner facilement deux géométries d'ailettes. Ainsi, les ailettes auxiliaires 406 peuvent être beaucoup plus fine et rapprochées que les ailettes principales 220, afin de mieux dissiper la chaleur. Ainsi, les dissipateurs de chaleur auxiliaires 402 peuvent être utilisés pour refroidir les parties du circuit électrique 202 dégageant le plus de chaleur. L'utilisation d'un isolant thermique entre chaque dissipateur de chaleur auxiliaire 402 et le dissipateur de chaleur principal 214, 220 permet d'éviter que de la chaleur ne soit transmise depuis les composants chauds vers les composants moins chauds du circuit électrique 202.

Par exemple, les ailettes auxiliaires 406 sont au moins quatre fois plus fines que les ailettes principales 220. Dans l'exemple décrit, les ailettes principales 220 ont une épaisseur e2 comprise entre 2 et 4 mm, par exemple 3 mm, tandis que les ailettes auxiliaires 406 ont une épaisseur e1 comprise entre 0,3 et 0,8 mm, par exemple 0,5 mm.

Par exemple encore, les ailettes auxiliaires 406 sont espacées d'un espacement E1 au moins trois fois plus petit qu'un espacement E2 entre les ailettes principales 220. Dans l'exemple décrit, les ailettes auxiliaires 406 sont espacées d'un espacement E1 compris entre 1,5 mm et 2,5 mm, par exemple 2 mm, tandis que les ailettes principales 220 sont espacées d'un espacement E2 compris entre 5 mm et 9 mm, par exemple entre 6 mm et 8 mm. Ainsi, la densité d'ailettes, c'est-à-dire le nombre d'ailettes se succédant dans la direction perpendiculaire à ces ailettes, peut être au moins trois fois plus élevée pour les ailettes auxiliaires 406 que pour les ailettes principales 220.

De manière générale, les dimensions sont imposées par l'état de l'art du ou des procédés de fabrication utilisé(s).

Il sera apprécié que les ailettes auxiliaires 406 sont intégrées parmi les ailettes principales 220. Cela se traduit par le fait que les ailettes auxiliaires 406 sont de préférence situées à une distance inférieure à cinq fois l'espacement E2 des ailettes principales 220. Cela se traduit en outre par le fait que les ailettes auxiliaires 406 d'au moins un des dissipateurs de chaleur auxiliaire 402 sont de préférence entourées par les ailettes principales 220 selon une direction D (dit autrement, il existe au moins une direction D traversant successivement des ailettes principales 220, des ailettes auxiliaires 406 et à nouveau des ailettes principales 220).

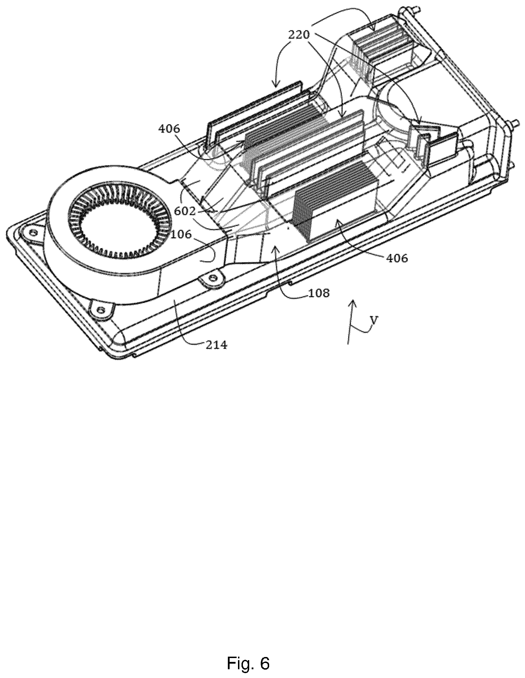

En référence à la figure 6 qui est une vue en trois dimensions de dessous du système électrique 100 avec le guide 108 en transparence, le guide 108 définit plusieurs gouttières 602 (trois dans l'exemple décrit) s'étendant contre la face inférieure du fond 214. Chaque gouttière 602 s'étend autour d'au moins une partie des ailettes principales 220 et/ou auxiliaires 406 de manière à délimiter avec le fond 214 un conduit de fluide de refroidissement. Dans l'exemple décrit où le fluide de refroidissement est de l'air, le ventilateur 106 est placé devant une entrée des conduits de manière à générer un flux d'air dans ces conduits d'air.

Le guide 108 (et les gouttières 602) pourrait être une pièce, par exemple une pièce plastique, rapportée contre la face inférieure du fond 214. Alternativement, le guide 108 pourrait être faire partie de la pièce inférieure 210, afin d'être d'un seul tenant avec le fond 214. Cette solution présente comme avantage d'améliorer l'étanchéité à l'interface entre le guide 108 et le fond 214, afin d'éviter les fuites de fluide de refroidissement, en particulier lorsque ce dernier est un liquide.

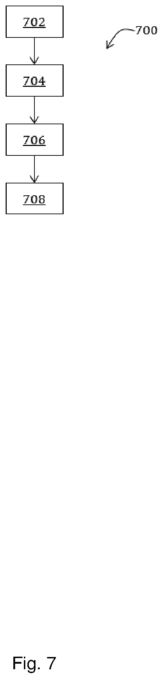

En référence à la figure 7, un exemple de procédé 700 de fabrication du dispositif de dissipation de chaleur des figures précédentes va à présent être décrit.

Au cours d'une étape 702, la pièce inférieure 210, et en particulier le dissipateur de chaleur principal 214, 220, est obtenue, par exemple par fonderie.

Au cours d'une étape 704, le ou les dissipateurs de chaleur auxiliaires 402 sont obtenus, par exemple par extrusion.

Au cours d'une étape 706, pour chaque dissipateur de chaleur auxiliaire 402, la colle 502 est appliquée sur sa collerette 408 et/ou sur la face supérieure du fond 214, et le corps auxiliaire 404 est placé dans l'ouverture 302 du fond 214 de sorte que la collerette 408 soit plaquée contre la face supérieure du fond 214, avec la colle 502 intercalée entre elles.

Au cours d'une étape 708, la colle 502 sèche de manière à fixer chaque dissipateur de chaleur auxiliaire 402 au dissipateur de chaleur principal 214, 220.

Alternativement, les étapes 706 et 708 pourraient être remplacées par une étape de vissage, brasure, soudure ou bien soudage par friction-malaxage (de l'anglais « friction stir welding »).

Les ailettes principales 220 et/ou les ailettes auxiliaires 406 peuvent être des ailettes autres que des ailettes droites à section constante.

## Revendications

1. Dispositif de dissipation de chaleur comportant un dissipateur de chaleur principal (214, 220) comportant un corps principal (214) présentant une face supérieure destinée à recevoir de la chaleur à dissiper, et des ailettes principales (220) s'étendant sur une face inférieure du corps principal (214) dans lequel le corps principal (214) est pourvu d'au moins une ouverture (302), ledit dispositif de dissipation de chaleur comportant en outre pour chaque ouverture (302), un dissipateur de chaleur auxiliaire (402) comportant un corps auxiliaire (404) placé dans l'ouverture (302) considérée, et des ailettes auxiliaires (406) s'étendant sur une face inférieure du corps auxiliaire (404) ledit dispositif de dissipation de chaleur étant **caractérisé en ce qu'**il comporte en outre un isolant électrique (502) intercalé entre chaque dissipateur de chaleur auxiliaire (402) et le dissipateur de chaleur principal (214, 220).

2. Dispositif de dissipation de chaleur selon la revendication 1, dans lequel les ailettes auxiliaires (406) et les ailettes principales (220) sont des ailettes droites à section constante et dans lequel les ailettes auxiliaires (406) présentent une épaisseur (e1) inférieure à une épaisseur (e2) des ailettes principales (220).

3. Dispositif de dissipation de chaleur selon la revendication 1 ou 2, dans lequel les ailettes auxiliaires (406) sont séparées les unes des autres d'un espacement (E1) inférieur à un espacement (E2) séparant les unes des autres les ailettes principales (220).

4. Dispositif de dissipation de chaleur selon l'une quelconque des revendications 1 à 3, dans lequel le dissipateur de chaleur principal (214, 220) est en une seule pièce d'un seul tenant.

5. Dispositif de dissipation de chaleur selon l'une quelconque des revendications 1 à 4, dans lequel chaque dissipateur de chaleur auxiliaire (402) est en une seule pièce d'un seul tenant.

6. Dispositif de dissipation de chaleur selon les revendications 4 et 5 prises ensemble, dans lequel le dissipateur de chaleur auxiliaire (402) est fixé au dissipateur de chaleur principal (214, 220) par un procédé de soudage par friction-malaxage.

7. Dispositif de dissipation de chaleur selon les revendications 4 et 5 prises ensemble ou selon la revendication 6, dans lequel le dissipateur de chaleur principal (214, 220) est obtenu par un premier procédé de fabrication, par exemple par fonderie, et dans lequel chaque dissipateur de chaleur auxiliaire (402) est obtenu par un deuxième procédé de fabrication, différent du premier, par exemple par extrusion.

8. Dispositif de dissipation de chaleur selon l'une quelconque des revendications 1 à 7, dans lequel chaque dissipateur de chaleur auxiliaire (402) comporte en outre une partie (408) se projetant latéralement du corps auxiliaire (404) de manière à être plaquée contre et fixée à la face inférieure du corps principal (214) du dissipateur de chaleur principal (214, 220).

9. Dispositif de dissipation de chaleur selon l'une quelconque des revendications 1 à 8, comportant en outre au moins une gouttière (602) s'étendant autour d'au moins certaines des ailettes principales (220) et/ou auxiliaires (406) de manière à délimiter avec le corps principal (214) au moins un conduit de fluide de refroidissement.

10. Dispositif de dissipation de chaleur selon la revendication 9, comportant en outre un système (106) de mise en circulation d'un fluide de refroidissement dans le ou les conduits de fluide de refroidissement.

11. Dispositif de dissipation de chaleur selon l'une quelconque des revendications 1 à 10, comportant en outre un isolant thermique (502) intercalé entre chaque dissipateur de chaleur auxiliaire (402) et le dissipateur de chaleur principal (214, 220).

12. Système électrique comportant un circuit électrique (202), tel qu'un convertisseur de tension continu-continu, et un dispositif de dissipation de chaleur du circuit électrique (202), selon l'une quelconque des revendications 1 à 11.

13. Procédé de fabrication d'un dispositif de dissipation de chaleur selon l'une quelconque des revendications 1 à 11, comportant :
a. l'obtention du dissipateur de chaleur principal,
b. l'obtention de chaque dissipateur de chaleur auxiliaire,
c. le placement du corps auxiliaire de chaque dissipateur de chaleur auxiliaire dans une ouverture respective du dissipateur de chaleur principal de sorte qu'un isolant électrique soit intercalé entre chaque dissipateur de chaleur auxiliaire et le dissipateur de chaleur principal et la fixation de chaque dissipateur de chaleur auxiliaire au dissipateur de chaleur principal.

## Patentansprüche

1. Wärmeableitungsvorrichtung, die einen Hauptwärmeableiter (214, 220) aufweist, der einen Hauptkörper (214) mit einer Oberseite, die dazu bestimmt ist, abzuleitende Wärme zu empfangen, und Hauptrippen (220) aufweist, die sich an einer Unterseite des Hauptkörpers (214) erstrecken, wobei der Hauptkörper (214) mit mindestens einer Öffnung (302) versehen ist, wobei die Wärmeableitungsvorrichtung außerdem für jede Öffnung (302) einen Hilfswärmeableiter (402) aufweist, der einen in der betrachteten Öffnung (302) angeordneten Hilfskörper (404) und Hilfsrippen (406) aufweist, die sich an einer Unterseite des Hilfskörpers (404) erstrecken, wobei die Wärmeableitungsvorrichtung **dadurch gekennzeichnet ist, dass** sie außerdem einen elektrischen Isolator (502) aufweist, der zwischen jeden Hilfswärmeableiter (402) und den Hauptwärmeableiter (214, 220) eingefügt ist.

2. Wärmeableitungsvorrichtung nach Anspruch 1, wobei die Hilfsrippen (406) und die Hauptrippen (220) gerade Rippen mit konstantem Querschnitt sind, und wobei die Hilfsrippen (406) eine Dicke (e1) geringer als eine Dicke (e2) der Hauptrippen (220) aufweisen.

3. Wärmeableitungsvorrichtung nach Anspruch 1 oder 2, wobei die Hilfsrippen (406) um einen Zwischenraum (E1) geringer als ein Zwischenraum (E2) voneinander getrennt sind, der die Hauptrippen (220) voneinander trennt.

4. Wärmeableitungsvorrichtung nach einem der Ansprüche 1 à 3, wobei der Hauptwärmeableiter (214, 220) aus einem einzigen einteiligen Bauteil besteht.

5. Wärmeableitungsvorrichtung nach einem der Ansprüche 1 bis 4, wobei jeder Hilfswärmeableiter (402) aus einem einzigen einteiligen Bauteil besteht.

6. Wärmeableitungsvorrichtung nach den Ansprüchen 4 und 5 zusammen gesehen, wobei der Hilfswärmeableiter (402) durch ein Reibrührschweißverfahren am Hauptwärmeableiter (214, 220) befestigt ist.

7. Wärmeableitungsvorrichtung nach den Ansprüchen 4 und 5 zusammen gesehen oder nach Anspruch 6, wobei der Hauptwärmeableiter (214, 220) durch ein erstes Herstellungsverfahren erhalten wird, zum Beispiel durch ein Gießverfahren, und wobei jeder Hilfswärmeableiter (402) durch ein zweites Herstellungsverfahren anders als das erste hergestellt wird, zum Beispiel durch Extrudieren.

8. Wärmeableitungsvorrichtung nach einem der Ansprüche 1 bis 7, wobei jeder Hilfswärmeableiter (402) außerdem einen Teil (408) aufweist, der seitlich vom Hilfskörper (404) vorsteht, um gegen die Unterseite des Hauptkörpers (214) des Hauptwärmeableiters (214, 220) gedrückt und daran befestigt zu werden.

9. Wärmeableitungsvorrichtung nach einem der Ansprüche 1 bis 8, die außerdem mindestens eine Ablaufrinne (602) aufweist, die sich um mindestens bestimmte der Haupt-(220) und/oder Hilfsrippen (406) erstreckt, um mit dem Hauptkörper (214) mindestens einen Kühlfluidkanal zu begrenzen.

10. Wärmeableitungsvorrichtung nach Anspruch 9, die außerdem ein System (106) aufweist, um ein Kühlfluid in dem Kühlfluidkanal oder den Kühlfluidkanälen zirkulieren zu lassen.

11. Wärmeableitungsvorrichtung nach einem der Ansprüche 1 bis 10, die außerdem einen thermischen Isolator (502) aufweist, der zwischen jeden Hilfswärmeableiter (402) und den Hauptwärmeableiter (214, 220) eingefügt ist.

12. Elektrisches System, das eine elektrische Schaltung (202) wie einen DC/DC-Spannungswandler und eine Wärmeableitungsvorrichtung der elektrischen Schaltung (202) nach einem der Ansprüche 1 bis 11 aufweist.

13. Verfahren zur Herstellung einer Wärmeableitungsvorrichtung nach einem der Ansprüche 1 bis 11, das aufweist:
a. den Erhalt des Hauptwärmeableiters,
b. den Erhalt jedes Hilfswärmeableiters,
c. das Einsetzen des Hilfskörpers jedes Hilfswärmeableiters in eine Öffnung des Hauptwärmeableiters derart, dass ein elektrischer Isolator zwischen jeden Hilfswärmeableiter und den Hauptwärmeableiter eingefügt wird, und die Befestigung jedes Hilfswärmeableiters am Hauptwärmeableiter.

## Claims

1. Heat dissipation device comprising a main heat sink (214, 220) comprising a main body (214) with an upper face intended to receive the heat to be dissipated, and main fins (220) extending over a lower face of the main body (214), wherein the main body (214) is provided with at least one opening (302), said heat dissipation device further comprising, for each opening (302), an auxiliary heat sink (402) comprising an auxiliary body (404) placed in the opening (302) concerned, and auxiliary fins (406) extending over a lower face of the auxiliary body (404), said heat dissipation device being **characterized in that** it further comprises an electrical insulator (502) which is interposed between each auxiliary heat sink (402) and the main heat sink (214, 220) .

2. Heat dissipation device according to Claim 1, wherein the auxiliary fins (406) and the main fins (220) are straight fins with a constant cross section, and wherein the auxiliary fins (406) have a thickness (e1) which is smaller than a thickness (e2) of the main fins (220) .

3. Heat dissipation device according to Claim 1 or 2, wherein the auxiliary fins (406) are separated from one another by a spacing (E1) which is smaller than a spacing (E2) which separates the main fins (220) from one another.

4. Heat dissipation device according to any one of Claims 1 to 3, wherein the main heat sink (214, 220) is made in a single integral part.

5. Heat dissipation device according to any one of Claims 1 to 4, wherein each auxiliary heat sink (402) is made in a single integral part.

6. Heat dissipation device according to Claims 4 and 5 taken together, wherein the auxiliary heat sink (402) is fastened to the main heat sink (214, 220) by means of a friction stir welding process.

7. Heat dissipation device according to Claims 4 and 5 taken together or according to Claim 6, wherein the main heat sink (214, 220) is obtained by means of a first manufacturing method, for example by casting, and wherein each auxiliary heat sink (402) is obtained by means of a second manufacturing method, which is different from the first method, for example by extrusion.

8. Heat dissipation device according to any one of Claims 1 to 7, wherein each auxiliary heat sink (402) further comprises a part (408) which projects laterally from the auxiliary body (404) so as to be placed against, and fastened to, the lower face of the main body (214) of the main heat sink (214, 220).

9. Heat dissipation device according to any one of Claims 1 to 8, further comprising at least one channel (602) which extends around at least some of the main fins (220) and/or auxiliary fins (406) so as to delimit, together with the main body (214), at least one cooling fluid duct.

10. Heat dissipation device according to Claim 9, further comprising a system (106) for circulating a cooling fluid in the cooling fluid duct or ducts.

11. Heat dissipation device according to any one of Claims 1 to 10, further comprising a thermal insulator (502) which is interposed between each auxiliary heat sink (402) and the main heat sink (214, 220).

12. Electrical system comprising an electrical circuit (202), such as a DC-to-DC voltage converter, and a heat dissipation device for the electrical circuit (202), according to any one of Claims 1 to 11.

13. Method for manufacturing a heat dissipation device according to any one of Claims 1 to 11, comprising:
a. obtaining the main heat sink;
b. obtaining each auxiliary heat sink;
c. placing the auxiliary body of each auxiliary heat sink in a respective opening of the main heat sink such that an electrical insulator is interposed between each auxiliary heat sink and the main heat sink, and fastening each auxiliary heat sink to the main heat sink.
